# EUROPÄISCHE PATENTANMELDUNG

(11) **EP 0 669 650 A2**
(43) Veröffentlichungstag der Anmeldung: **30.08.1995**
(21) Anmeldenummer: 95101712.8
(22) Anmeldetag: 08.02.1995
(51) Int. Cl.: H01L 23/057

(54) **Gehäuste Halbleiteranordnung und Verfahren zu deren Herstellung**

(30) Priorität: 22.02.1994 DE 4405645
(71) Anmelder: SIEMENS AKTIENGESELLSCHAFT, 80333 München (DE)
(72) Erfinder: Fischbach, Reinhard, Dipl.-Ing., D-13627 Berlin (DE); Houdeau, Detlef, Dr., D-12161 Berlin (DE); Hubrich, Frank, Dipl.-Ing., D-93186 Pettendorf (DE); Lösch, Harald, Dipl.-Ing., D-93077 Bad Abbach (DE)

(57) **Zusammenfassung**

Die technische Entwicklung bei IC-Gehäusen zielt nicht nur in Richtung auf höhere Integration, höhere Anschlußzahlen, sondern auch auf geringere Bauhöhe. So werden mittlerweile für die Bauformen QFP, TSOP, UTSOP Montagehöhe von 0,8 mm, 1,0 mm bzw. 0,5 mm erreicht. Die bisherige Vorgehensweise aus einer Kombination von Verringerung der Chipdicke durch Rückseitendünnung nach der Vorderseitenstrukturierung und der Einsatz von partiell dünneren Leadframes bei konstanter Die-Bondtechnik stößt an physikalische Grenzen. Es wird ein System aus Chip 1 und Leadframe vorgeschlagen, das die Rückseite eines Chips 1 durch mechanischen Abtrag strukturiert und die korrespondierende Struktur im Fügebereich eines Leadframes darin versenkt.

## Beschreibung

Die Erfindung betrifft ein Chip-Gehäuse, bestehend aus einem integrierten Schaltkreis (Chip), einem Systemträger, wie beispielsweise ein Leadframe, und einer Umhüllung aus Kunststoff. Weiterhin wird ein verfahren zu dessen Herstellung angegeben.

Die Verbindung zwischen einem Chip und einem Substrat, also das Aufbringen des Chips mit seiner Rückseite auf das Substrat wird Chip- oder Die-Bonding genannt. Dabei müssen die Forderungen an die Verbindung hinsichtlich mechanischer Festigkeit, guter thermischer und elektrischer Leitfähigkeit je nach Anwendungsfall entsprechend erfüllt sein. Eine besondere Rolle spielt hier die Vertraglichkeit von Chip und Substrat, d.h. die Anpassung beider Verbindungspartner in ihrem Ausdehnungsverhalten bei thermischer Belastung. Diesbezüglich müssen in der Regel Kompromisse eingegangen werden, da fast nie gleiche Materialkennwerte vorliegen. Als Verbindungsverfahren werden im wesentlichen drei Verfahren eingesetzt, Kleben, Löten und eutektisches Bonden.

Die zweite herzustellende Verbindung betrifft die elektrische Kontaktierung des Chips mit den inneren Anschlüssen eines Substrates. Hierbei werden großtechnisch gewalzte und gestanzte Bänder, sog. Leadframe-Bänder, eingesetzt. Diese weisen die inneren, d.h. auf den Chip gerichteten, und die äußeren, d.h. in Richtung Leiterplatte befindlichen elektrischen Anschüsse auf, wobei zentral eine großflächige Insel vorhanden ist, auf der der Chip mit seiner Unterseite mittels Die-Bonden entsprechend befestigt wird. Dabei sind die Materialpaarungen, Konstruktionen und Herstellungsverfahren äußerst zahlreich. Bezüglich der Kontaktierung gibt es beispielsweise die Drahtkontaktierung, Spider-Kontaktierung und Flip-Chip-Kontaktierung.

Der auf die mechanische und elektrische Verbindung des Chips folgende wesentliche Verfahrensschritt ist die Einkapselung in Kunststoff. Dies geschieht in den weitaus meisten Fällen mit einer Preßmasse unter Energiezufuhr, d.h. bei erhöhter Temperatur von beispielsweise ca. 300 C. Dabei entstehen starke Geometrieabweichungen durch Verbiegungen, was mit "Warpage" bezeichnet wird.

Der Trend in der Chip- und Chip-Gehäuseentwicklung geht seit einigen Jahren zu höherer Integration, höheren Anschlußzahlen und geringerer Bauhöhe. Dies ist einigen Artikeln zu entnehmen, wie beispielsweise -Lewis, S.; Backgrinding Wafers for Maximum Die Strength; Semiconductor International (1992, Seite 86 ff)-. Die geringere Bauhöhe wird für unterschiedliche Typen angestrebt, so daß beispielsweise eine Montagehöhe von 0,8 mm mit der Bezeichnung QFP (Quad flat package), eine Montagehöhe von 1,0 mm mit der Bezeichnung TSOP (Thin Small Outline Packages) und eine Montagehöhe von 0,5 mm mit der Bezeichnung UTSOP (Ultra...) jeweils verbunden ist. Eine Montagehöhe von 0,5 mm ist mit einer Gehäusedicke von 0,45 mm verbunden. Den ersten 4M-DRAM und 1M-SRAM in TSOP bietet die Firma Hitachi bereits an. Eine ähnliche Entwicklung zeichnet sich bei den QFP's ab.

Bei der genannten Entwicklung bezüglich der Bauhöhe wird im wesentlichen die Chipdicke durch Rückseitendünnung nach der Vorderseitenstrukturierung und durch den Einsatz partiell dünnerer Leadframes (LF) bei unveränderter Die-Bondtechnologie erreicht. Dabei sitzt der Chip huckepack auf dem LF. Diese beiden Verfahren stoßen jedoch an physikalische Grenzen. Mit abnehmender Chipdicke nimmt die Gefahr des Waferbruches durch das Rückseitendünnungsverfahren zu. Das Flachschleifen kann beispielsweise mit Diamant geschehen. Beim Kassetten-Bestücken kann es zu Handlingsproblemen bei stark verbogenen Wafern kommen. Außerdem entstehen nach dem Die-Bonden auf dem Leadframe stark verformte Chips, da die Chipsteifigkeit mit abnehmender Chipdicke deutlich geringer wird. Hinzu kommt, daß ein dünneres Leadframe-Material im Bereich der zentralen Fügeinsel herstellungstechnisch aufwendig und damit teuer ist. Das gesamte Leadframeband kann nicht dünner gewählt werden, da damit zwangsläufig auch die Pins im Querschnitt abnehmen würden und gleichzeitig eine Verschlechterung der Oberflächenmontage bzw. der herkömmlich bedrahteten Montage mit sich bringen würde. Die Wärmeabfuhr wird durch dünnere Metallquerschnitte nach außen hin ebenfalls geringer.

Der Erfindung liegt die Aufgabe zugrunde, eine gehäuste Halbleiteranordnung bereitzustellen, deren Bauhöhe vermindert ist, wobei gleichzeitig Probleme der Geometrieabweichungen, d.h. Verbiegungen, minimiert werden sollen. Zusätzlich soll ein Verfahren zur Herstellung einer solchen Halbleiteranordnung kostengünstig beschrieben werden.

Die Lösung dieser Aufgabe geschieht durch den Gegenstand des Anspruches 1 bzw. des Anspruches 4.

Der Erfindung liegt die Erkenntnis zugrunde, daß durch Vergraben der Leadframeinseln auf der Chipunterseite mit gleichzeitigem Dünnen des Chips die Gesamtbauhöhe reduziert werden kann. Dabei ist eine höhere Eigenstabilität des Systems Chip-Substrat beim Umhüllen mit Preßmasse vorhanden. Das Leadframeband kann über die gesamte Abmessung in der Dicke bzw. Stärke konstant gehalten werden. Die Verbiegung, das sog. "Warpage" ist wesentlich geringer als bisher.

Das Vergraben der Leadframeinseln auf der Rück- bzw. Unterseite des Chips geschieht durch deckungsgleiche Strukturierung dieser Rückseite mit dem entsprechenden Fügebereich des Leadframes. Dazu wird auf der Chipunterseite eine Struktur aufgebracht, in der ausgewählte Stellen in Form von Nuten oder flächigen Abtragungen mit jeweils der gleichen Tiefe ausgebildet sind. Die Struktur des Leadframes ist derart ausgebildet, daß sie in die Struktur der Gräben und tiefergesetzten flächigen Wannen auf der Rückseite des Chips hineinpaßt.

Eine besonders vorteilhafte Ausgestaltung der Erfindung sieht eine Struktur auf der Rückseite des Chips vor, die sich kreuzende und diagonal zum Chipumriß verlaufende Nuten beinhaltet.

Zur Herstellung der Halbleiteranordnung wird die Rückseitenstrukturierung mit Gräben und Wannen nach Abschluß der Vorderseitenstrukturierung ausgeführt. Der Wafer wird frontseitig mit einer aufgeklebten Schutzfolie versehen, fixiert und unter Strahldüsen, insbesondere Sandstrahldüsen, hin-und herbewegt, wobei der selektive Abtrag entsprechend einer waferrückseitig aufgebrachten Maske vorgenommen wird. Die Zeit der Bestrahlung eines jeden Ortes bestimmt die entsprechende Tiefe der Nut oder der Wanne. Die rückseitige Maske kann fotolithografisch hergestellt sein oder kann beispielsweise eine weiche Metallmaske sein, die wiederholt einsetzbar ist. Nach einer Reinigung mit destilliertem Wasser kann die Positionierung relativ zu dem Systemträger/Leadframe vorgenommen werden. Die bei der Herstellung verwendete Maske und die daraus resultierenden Strukturen sind relativ zur Vorderseitenstruktur des Chips bzw. zum (Säge)flat, das die kristastallografische Orientierung und den Leitfähigkeitstypes der Anordnung kennzeichnet, ausgerichtet.

Im folgenden werden anhand der schematischen Figuren Ausführungsbeispiele beschrieben.

Figur 1 zeigt einen Chip 1 mit tiefergesetzter und flächig ausgebildeter Wanne 2 und Gräben bzw. Nuten 3,
Figur 2 zeigt ebenfalls diagonal verlaufende Nuten 3, die in ein zentral gelagertes Quadrat, das ebenfalls aus Nuten 3 gebildet wird, münden,
Figur 3 zeigt kurze, diagonal von den Ecken eines Chips 1 aus nach innen gerichtete Nuten 3,
Figur 4 deutet die Abrundung der Ecken und Kanten der Nuten 3 an,
Figur 5 stellt einen quadratischen Chip 1, sowie einen rechteckigen Chip 11 dar, wobei die Stege 5 des Leadframes angedeutet sind.

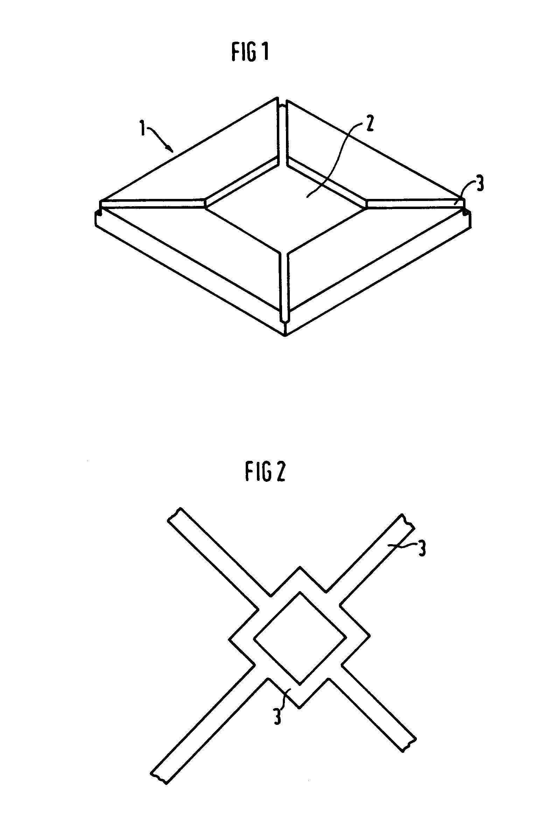

In der Figur 1 werden die in der Struktur auf der Rückseite eines Chips 1 eingearbeiteten Wannen 2 und Nuten 3 dargestellt. Es ist erkennbar, daß die Kontaktierung mit einem Systemträger (Leadframe) nicht mehr vollflächig geschieht. Der vorderseitig strukturierte und rückseitig bereits in seiner Stärke/Dicke verdünnte Chip 1 wird also auf einen Leadframe aufgesetzt, der die entsprechende deckungsgleiche Struktur hat, so daß dieser mit seinem Fugebereich in der rückseitigen Struktur des Chips 1 in den Wannen 2 und den Nuten 3 versenkbar ist. Hierzu ist es notwendig, daß die Nuten 3 zumindest teilweise bis zum Rand der Chipfläche reichen. In der Regel wird die Verteilung der am Rand des Chips 1 auslaufenden Nuten, bezogen auf den Umfang, gleichmäßig sein.

Entsprechend Figur 2 kann im zentralen Bereich der Struktur auf der Rückseite eines Chips 1 auch eine nicht tiefergelegte Insel 4, die von Nuten 3 umrandet wird, vorgesehen sein. Durch diese Ausgestaltung wird die Kontaktfläche zwischen Chiprückseite und Leadframe nochmals verkleinert.

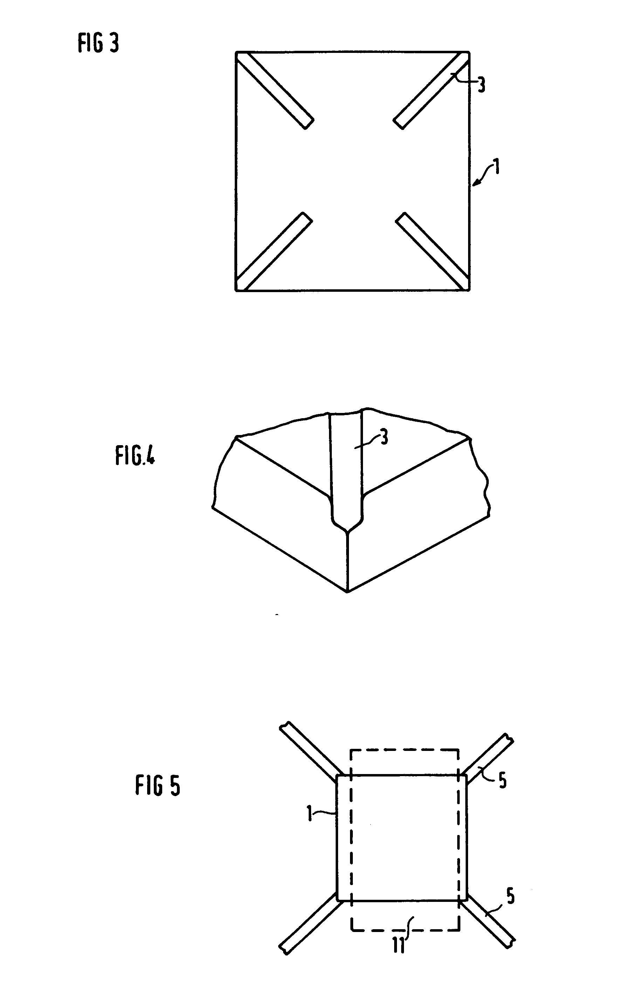

Wie in Figur 3 dargestellt, ist auch eine rückseitige Chipstruktur möglich, die keinerlei Inselgeometrie zeigt, weder eine großflächige Wanne 2, noch eine Insel 4. Entsprechend Figur 5 können unterschiedliche Chipformen vorliegen, beispielsweise quadratische oder rechteckige.

Die Ecken, Ränder und Kanten der Wannen 2 und der Nuten 3 können abgerundet werden, was zur Verringerung der Kerbwirkung beiträgt. Diese Abrundung ist in Figur 4 angedeutet.

Die Herstellung der rückseitigen Struktur aus Nuten und Wangen kann durch verschiedene Abtragstechniken bewirkt werden. Hierbei ist naßchemisches Ätzen möglich. Das beanspruchte Verfahren arbeitet jedoch mit Strahlen, wobei kleine Partikel durch einen Gasstrom auf das Werkstück geschleudert werden und entsprechende mechanische Abtragungen verursachen. Dies wird in der deutschen Industrienorm DIN 8200 beschrieben. Als Strahlmittel sind beispielsweise Partikel aus Aluminiumoxid, Siliziumoxid, Siliziumcarbid oder Borcarbid denkbar. Die rückseitige fototechnisch hergestellte Maske kann beispielsweise auch eine auflamellierte und fototechnisch entwickelbare Fotofolie sein.

Durch das genannte Verfahren können Abtraggeschwindigkeiten von 0,5 bis 2 mm/s erreicht werden. Entsprechend der Relativgeschwindigkeit zwischen Werkstück und Strahldüse wird sich eine entsprechende Abtragtiefe ausbilden. Fur den Durchlauf eines 6"-Wafers werden etwa 100 s benötigt. Vorteile des Strahlens, umgangssprachlich bekannt unter Sandstrahlen, gegenüber einem anderen Abtragsverfahren wie naßchemischem Ätzen, beispielsweise mit HF oder HN0₃, liegen in der einfachen Maskentechnik. Die Maske kann einfach hergestellt werden bzw. mehrmals benutzt werden. Das Abtragungsmedium greift im Falle des Partikelbeschusses nicht die Vorderseitenstruktur an. Dadurch werden z.B. freiliegende Aluminium-Pads nicht angegriffen. Bei Verwendung von Ätzlösungen ist dies nicht sichergestellt. Die Abtragungsgeschwindigkeit des Sandstrahlens mit Korund ist sehr hoch und eine Automatisierung ist leicht möglich.

Mit dem Verfahren können rauhe Wannenbodenoberflächenqualitäten erzeugt werden. Die maximale Rauhigkeit Rₘₐₓ kann von 0,5 bis 2 um reichen. Diese Rauhigkeit eignet sich für Klebemontagen. Dazu sind zwei Verbindungstechniken möglich, von denen die eine die zusammengefügten Teile mit einem Standardkleber klebt, der ganzflächig wirkt und die andere Verbindungstechnik die Verbindung nur über Stege des Leadframes herstellt, die mit Thermoplast beschichtet sind und heißgefügt werden.

Neben dem hauptsächlichen Vorteil der Verringerung der Dicke der Anordnung auf ca. 150 bis 200 um übernehmen die korrespondierenden Strukturen auf der Rückseite des Chips 1 und im Fügebereich des Leadframes zusätzlich eine Positionierfunktion. Somit ist die genaue lagerichtige Ausrichtung des Chips 1 mit seiner Vorderseitenstruktur relativ zum Leadframe erzielbar.

Durch die entsprechend der Erfindung nicht vollflächige Montage einer Chiprückseite auf eine zentrale Fügefläche bzw. Fügestruktur eines Leadframes, was einem Ineinandergreifen bzw. Versenken der zu fügenden Partner entspricht, kann eine hohe Steifigkeit des Chipkörpers beibehalten werden und trotzdem eine insgesamt niedrige Bauhöhe erzielt werden.

Bei der anschließenden Einbettung in eine Kunstmasse bei erhöhter Temperatur und dem darauffolgenden Abkühlen zeigt eine derartige Halbleiteranordnung ein geringes Warpage.

## Patentansprüche

1. Gehäuste Halbleiteranordnung, bestehend aus einem mit seiner Rückseite auf einem Systemträger befestigten Chip (1) und einer Kunststoffumhüllung mit nach außen zugänglichen elektrischen Anschlußelementen, wobei
- der rückseitig verdünnte Chip (1) an seiner Rückseite eine Struktur aus Nuten (3) oder aus einer Kombination von Nuten (3) und tiefergesetzten flächigen Wannen (2) mit annähernd gleicher Tiefe ausweist, und zumindest ein Teil der Nuten (3) bis zum Rand des Chips (1) reicht,
- der Fügebereich des Systemträgers entsprechend dieser Struktur ausgebildet ist und
- die Struktur des Systemträgers in den Nuten (3) oder Wannen (2) des Chips (1) in befestigtem Zustand teilweise oder vollständig versenkt ist.

2. Gehäuste Halbleiteranordnung nach Anspruch 1,
dadurch gekennzeichnet, daß die Nuten (3) kreuzförmig und diagonal auf der Rückseite des Chips (1) verlaufen.

3. Gehäuste Halbleiteranordnung nach Anspruch 2,
dadurch gekennzeichnet, daß die Nuten (3) in eine zentral auf der Rückseite des Chips (1) positionierte tiefergesetzte flächige Wanne (2) einmünden.

4. Verfahren zur Herstellung einer gehäusten Halbleiteranordnung nach einem der Ansprüche 1 bis 3, wobei
- die strukturierte Vorderseite des Chips (1) mit einer aufgeklebten Schutzfolie abgedeckt wird,
- die Rückseite des Chips (1) mit einer fotolithografisch hergestellten Maske oder einer aufgesetzten Metallmaske zur Herstellung der Struktur versehen wird,
- die rückseitige Maske relativ zu der Struktur der Vorderseite bzw. relativ zum Flat ausgerichtet wird und
- die selektive mechanische Materialabtragung zur Herstellung der Struktur auf der Rückseite des Chips (1) durch Strahlen geschieht.
